# EUROPEAN PATENT APPLICATION

(11) **EP 4 653 951 A1**
(43) Date of publication of application: **26.11.2025**
(21) Application number: 24176822.5
(22) Date of filing: 20.05.2024
(51) Int. Cl.: G03F 7/00

(54) **METHOD AND SYSTEM FOR DETERMINING A POSITION SENSOR ERROR**

(71) Applicant: Mycronic AB, 183 03 Täby (SE)
(72) Inventor: Walther, Jonas, 169 37 Solna (SE)
(74) Representative: AWA Sweden AB

(57) **Abstract**

A method for determining a position sensor error in a substrate pattern system, wherein the substrate pattern system comprises a control unit, a movable component, a base, and at least one position sensor having a fundamental period and configured to measure a position of the movable component along at least one axis, the method comprising: moving (110) the movable component relative the base with a predetermined speed along the at least one axis, generating (120) position data indicating a position of the movable component relative the base, by the at least one position sensor, sampling (130) the position data with a sampling rate to generate sampled position data, wherein the sampling rate is based on the fundamental period of the at least one position sensor, calculating (140), by the control unit, the position sensor error along the at least one axis of the at least one position sensor based on the sampled position data, the predetermined speed and the sampling rate.

## Description

### TECHNICAL FIELD

The present disclosure generally relates to the field of substrate pattern systems. In particular, the present disclosure relates to a method for determining and compensating for a position sensor error in a system related to microlithography.

### BACKGROUND

In optical microlithography an optical beam is focused onto a substrate using projection optics, wherein a photo-sensitive resist provided on the substrate may be exposed to the beam. Different regions of the substrate may be exposed to the beam, thereby creating a pattern. Optical microlithography can create very small patterns, down to nanometer size, and provide a precise control of the design of the pattern. The positioning of the projection optics relative the substrate is therefore important for the performance of the microlithographic process. After a microlithographic process of a substrate, the patterned substrate may be examined using optical components. For example, the placement of the pattern on the substrate may be measured, or defects of the patterned substrate may be inspected and detected. In a system which may either measure the placement of the pattern of the patterned substrate or inspect the patterned substrate to find defects, the positioning of the substrate, usually relative the optical components, is important for the performance of the system.

A system that generates patterned substrates or in some way measures or inspects a patterned substrate may be equipped with different types of position sensors in order to provide information of the substrate relative e.g. an optical component. The accuracy and the level of vibrations in the positioning system may be highly dependent on the linearity of the sensors.

A common problem among position sensors in this field are that the increased resolution may give rise to one or more position errors. The position sensor error may cause placement errors affecting a microlithographic process, a measurement process or an inspection process, of a substrate. The position error may also cause an affect in the movements during any of these processes due to e.g. alias frequency problems. All this may result in a degradation of the accuracy of the positioning system, and thereby a degradation of the performance of a microlithographic process, a measurement and/or an inspection of the substrate.

Therefore, in order to ensure the accuracy and the performance of the system during a microlithographic process, a measurement, or an inspection of a substrate processed by microlithography, there is a still a need to provide an improved method to detect position sensor errors and compensating for the detected position sensor error.

### SUMMARY

One general aim of the present disclosure is to provide a way to account for a position sensor error in a positioning system for a substrate pattern system. Specifically, there is a desire to be able to detect, measure or determine a position sensor error in a positioning system. Furthermore, there is a desire to be able to correct or compensate for the detected position sensor error in the positioning system for the substrate pattern system.

It is therefore an object of the present disclosure to overcome at least some of the above-mentioned drawbacks, and to provide an improved accuracy of the position system in, e.g., a substrate pattern system, and thereby improve performance and quality of the substrate pattern system. This and other objects are achieved by means of a method for determining a position sensor error in a substrate pattern system, a method for compensating for a position sensor error in a substrate pattern system, and a substrate pattern system as defined in the appended independent claims. Other embodiments are defined by the dependent claims.

According to a first aspect of the present disclosure, a method for determining a position sensor error in a substrate pattern system is provided. The substrate pattern system comprises a control unit, a movable component, a base, and at least one position sensor. The at least one position sensor have a fundamental period and is configured to measure a position of the movable component along at least one axis. The method comprises moving the movable component relative the base with a predetermined speed along the at least one axis. The method further comprises generating position data indicating a position of the movable component relative the base, by the at least one position sensor. The method further comprises sampling the position data with a sampling rate to generate sampled position data. The sampling rate is based on the fundamental period of the at least one position sensor. The method further comprises calculating, by the control unit, the position sensor error along the at least one axis of the at least one position sensor based on the sampled position data, the predetermined speed and the sampling rate.

The substrate pattern system may be a system for writing, measuring, inspecting or otherwise treating or evaluating a microlithography pattern on a substrate.

It is to be understood that the different steps of the method are performed, e.g. automatically, by the components/parts of the substrate pattern system. The steps of the method may be at least partially achieved by means of a control unit/computer. The moving of the movable component, the sampling the position data and/or the calculating of the position sensor error may be controlled and/or performed by a control unit, e.g. by a program on a control unit. By "control unit" it is here meant any type of processing unit, such as a computer. It is to be understood that the formulation "along the at least one axis" may mean in a direction parallel with the at least one axis, e.g. the movable component may be moved relative the base with a predetermined speed in a direction parallel with the at least one axis.

The present disclosure relates to the idea of providing a method for determining a position sensor error in a substrate pattern system that may provide increased accuracy and quality within optical microlithography. The present disclosure also relates to the idea of providing an efficient method for determining a position sensor error that may improve the positioning of a substrate that in some way is being processed in a substrate pattern system. The method for determining a position sensor error may be employed in systems where the optical microlithography is used and/or in systems that in some way examines, measures, or inspects a substrate that has been processed using optical microlithography.

Furthermore, the present disclosure provides a solution that allows improved operation, such as placement, during all processes related to substrate pattern systems when a position sensor is used, such as for measurement/inspection/writing of a substrate pattern. Hence, the present disclosure may reduce the demand on mechanical alignment for substrate pattern systems.

A substrate pattern system may be a microlithography system, and/or a system for microlithography. The term "microlithography system" here includes all systems related to microlithography, such as systems for writing patterns in a substrate, and for systems that measure and inspect the patterned substrate.

Optical microlithography is a technique where an optical beam, i.e. light, is used to generate a pattern on/in a substrate. The substrate may be provided with a thin coating of suitable material, such as a photo-sensitive resist. Thereby, a pattern may be formed as different regions of the photo-sensitive resist is exposed to the optical beam. A process using optical microlithography may create features in the micrometer range or less. A microlithography system may be a nanolithography system, and may be understood to include pattern substrate systems for scales/features both in the micrometer and the nanometer range. A nanolithography system may be capable of writing, measuring, or inspecting nanoscale patterns on a substrate, such as patterns having features smaller than 100 nm. A substrate pattern system may be a system and/or a device using optical microlithography to produce a patterned substrate. Such a system may for example be a pattern generator or a mask writer.

A substrate pattern system may also be a measurement system and/or device that measures at least a part of the pattern, the correctness of the pattern and/or a part of the pattern, of a patterned substrate. In an example of such a measurement system/device, the substrate is illuminated and high-resolution images of the substrate are captured, based on which measurements may be made. The measurement may be performed by measuring the deviations or the differences between an expected and an actual X- and Y-position of a set of reference structures provided in the patterned substrate. This type of measurement may also be referred to as pattern registration or pattern placement, and in those cases where the patterned substrate is a photo mask it may be referred to as mask metrology or mask position measurement.

A substrate pattern system may also be an inspection system and/or device that inspects or examines a substrate or a patterned substrate in order to find potential defects of the substrate or the patterned substrate. Examples of such defects may be dust or other particles that contaminates the substrate or patterned substrate. An example of such an inspection system/device scans the substrate, using e.g. a line scan sensor, to identify potential pattern errors or contamination of the substrate.

The substrate pattern system may comprise different components depending on the application of the substrate pattern system as described above. The substrate pattern system may be a system for writing, measuring, inspecting or otherwise treating or evaluating a microlithography pattern on/in a substrate. Hence, it is to be understood that the substrate may be any substrate present when writing, measuring, inspecting or otherwise treating or evaluating in a microlithography system. For example, a substrate may refer to a photo mask, and/or it may refer to a substrate in a direct writing microlithography system, i.e. maskless writing microlithography.

The movable component may be movable in relation to the base. For example, the movable component may be a carriage, a tool head, a substrate holder, a platform or a stage. The base may be a bridge, a beam, a bar, a substrate holder, a platform, a stage, or a base stone. The carriage or the tool head may comprise optical components, such as lenses, mirrors, prisms, beam splitters, deflectors, modulators, etc., arranged and configured to focus an optical writing beam onto the substrate, or to collect and guide light from a target positions on the substrate to an imaging, scanning or other recording sensor. The tool head may comprise an objective lens having a focal point at the substrate.

The carriage and the tool head may be configured to focus and/or gather light onto or from a substrate. The substrate holder, the platform or the stage may be configured to receive a substrate. A substrate may be arranged and/or placed on the platform or the stage or in the substrate holder. The base stone may be a dense/solid structure, e.g., a thick plate with high density. In an example, the movable component may be a tool head movably arranged on, e.g., a bridge. The tool head may move relative, and along, the bridge. In another example, the movable component may be a platform movably arranged on the base stone. The platform may move relative the base stone. The at least one position sensor may be configured to sense, measure, detect, and/or determine a position and/or a displacement of an object such as the movable component and/or the base. The at least one position sensor measures along at least one axis. The physical objects that embody the movable component and the base, respectively, may change depending the at least on axis along which a position sensor error may be determined. For example, along a first axis A₁, a carriage may be moved relative a bridge, and along a second axis A₂, a platform may be moved relative a base stone. The at least one position sensor may be configured to measure a position of the carriage along the first axis A₁, and measure a position of the platform along the second axis A₂. The at least one position sensor may be an optical sensor, i.e. a type of sensor that uses light to detect and/or measure certain physical properties or environmental conditions. The at least one position sensor may for example be an encoder or an interferometer. It is to be understood that the substrate pattern system may comprise one or more encoders and/or one or more interferometers.

In a general example for periodic signals, the fundamental period, or cycle length, is the smallest, non-zero, distance that a graph can be shifted to the right or left so that it lies on top of an original graph. Thereby, the errors in a fundamental period are repeated in the next fundamental period. This is the typical case in discrete Fourier analysis.

For position sensors that measure linear or angular displacement, distance, or length, the fundamental period may be expressed in distance units, such as meters (m) or millimeters (mm). For sensors that measure dynamic changes overtime, e.g. sensors used in signal processing applications, the fundamental period may be expressed in time units, such as seconds (s) or milliseconds (ms). For some position sensors the fundamental period may be expressed in a distance unit and/or a time unit.

For further understanding, a resolution of the at least one position sensor may refer to the smallest increment of linear or angular displacement that the sensor can detect. Hence, the resolution may represent the smallest detectable changes in position, while the fundamental period may relate to the smallest changes in position.

The fundamental period, FP, of the at least one position sensor may be determined by the type of position sensor, the system components, one or more settings/properties of the system components, and/or the properties of the position sensor. The fundamental period may be defined as the shortest distance that an optical pattern or a waveform repeats itself, and/or the smallest change in position that the at least one position sensor may measure or detect without interpolation of the measurements made by the at least one position sensor. The fundamental period of the at least one position sensor may be expressed or specified in a unit of distance, such as meter/micrometer/nanometer. An optical pattern may be a specific arrangement of opaque and/or transparent regions on a disk, a scale, or a lattice. The optical pattern may be a fine grid pattern, often called a scale or encoder strip, which is placed on a reference surface, usually on, e.g., the stage, or another component whose position needs to be monitored. An optical sensor, which can be either photodiodes or phototransistors, may be used to read the grid pattern. These sensors detect changes in light intensity as the grid lines pass by, converting these changes into electrical signals. For example in the case of an encoder, the position sensor may comprise and use a light source and an optical pattern, to read or detect a series of discernible/distinguishable regions, e.g. a series of light and dark periods or regions.

A waveform may be a pattern of light and dark regions. A waveform may be a sinusoidal wave, such as light emitted by a laser.

The position sensor error may occur/appear within each fundamental period. The position sensor error may have the same period as the fundamental period. The position sensor error may be fixed within the fundamental period and thereby repeat itself each fundamental period. The position sensor error may be periodic and/or cyclic. The frequency of the position sensor error may depend on the predetermined speed and the period of the position sensor error.

In an example, the fundamental period of an encoder may be the grating pitch of the encoder, that is, the spacing between adjacent lines or marks, or the spacing between opaque and transparent regions, arranged on the scale or the disk of the encoder.

In another example, the fundamental period of an interferometer may be the wavelength of the laser used in the interferometer. In the case of an interferometer, interference phenomenon is used. When two or more coherent light waves overlap, they interfere with each other, resulting in a pattern of alternating bright and dark fringes. This pattern is known as an interference fringe pattern. The interference fringe pattern forms a waveform that contains information about the phase difference between the interfering light waves. This waveform can be analyzed to extract various parameters, such as the distance traveled by the light, the thickness of optical components.

By moving the movable component relative the base along the at least one axis the movable component may move linearly along the axis. In an example, the movable component may be movably arranged on the base, thereby configured to move along the base, i.e. relative the base. The base may extend along the at least one axis. The predetermined speed may be a speed set by an operator of the substrate pattern system, a predetermined speed and/or a speed determined by a control unit comprised in or connected to the substrate pattern system. The predetermined speed may vary depending on the substrate pattern system, the movable component, the base, and/or the at least one position sensor. It is to be understood that the predetermined speed of the movable component may be calculated before the process of determining the position sensor error and externally to the substrate pattern system. In other words, the method may comprise receiving the predetermined speed for the moveable component. For example, from a computer or memory, which may or may not be part of the substrate pattern system.

The at least one position sensor may be configured to generate position data. The position data may comprise a measured position of the movable component along/on the at least one axis. The position data may comprise a position of the base, which for example may be known or used as reference. The position of the base may be known or predetermined by a control unit comprised in or connected to the substrate pattern system. The movable component, the base and/or the at least one position sensor may be defined, arranged or placed in a reference coordinate system comprising an X-axis and a Y-axis. The position data may comprise a measured position of the movable component in the reference coordinate system based on the position of the base and/or the position of the at least one position sensor. The position data may be a continuous signal or feed of data indicating a position of the movable component relative the base.

Sampling the position data with a sampling rate to generate sampled position data may be performed together with or simultaneously as generating position data indicating a position of the movable component relative the base, by the at least one position sensor. For example, the sampling may be performed in or by the at least one position sensor and/or other processing circuitry such as a control unit. The sampling may be performed simultaneously as the generation of position data. By "sampling" it is herein meant selecting or measuring discrete values of the position data at certain intervals in time. The position data is sampled with a sampling rate. The sampling rate may be defined as the average number of samples, i.e. discrete values of the position data, obtained in one unit of time, for example in one second. The sampling rate may be expressed or specified in samples per second, i.e. Hertz. The sampling rate may also be referred to as sampling frequency. The sampling rate may be based on the at least one position sensor and its fundamental period. For example, a number of samples per fundamental period may be preferred or suitable thereby affecting the sampling rate. It is to be understood that the fundamental period of the at least one position sensor may be known for each position sensor. In other words, the method may comprise receiving information of the fundamental period of the at least one position sensor. For example, from a computer or a memory, which may or may not be part of the substrate pattern system.

Calculating the position sensor error along the at least one axis of the at least one position sensor may be performed in a control unit and/or processing unit comprised in or connected to the microlithography device. Calculating the position sensor error may comprise processing of the sampled position data. By moving the movable component relative the base with a predetermined speed and sampling the position data with a sampling rate the position sensor error may be determined in a facilitated and efficient way since a constant speed may be assumed as reference. The sampling rate and the predetermined speed being known may result in a linear relationship between the position of the movable component and time, or, phrased differently, the position of the movable component may be a linear function of time. By this, the deviations and/or the linear detrends of the sampled position data may, at least partly, correspond to measurement errors of the position sensor, such as the position sensor error. In an example, the calculating of the position error may comprise linear detrending of the sampled position data based on the sampling rate and the predetermined speed. By this a linear detrend of the sampled position data may be obtained in which subtrends or deviations may be analyzed, such as the position sensor error. The sampled position data and/or its linear detrends or deviations may be processed in different ways to provide processed sampled position data, i.e. to achieve a cleaner signal of the position sensor error. The use of the processed sampled position data may thus provide improved determination of the position sensor error, e.g. in terms of accuracy.

The method according to a first aspect of the present disclosure may provide an efficient and facilitated determination of the position sensor error since the method may be performed in-situ in a substrate pattern system and without any additional position sensors or external references. The at least one position sensor comprised in the substrate pattern system is configured to generate position data which is being used to determine the position sensor error of the same.

Furthermore, by selecting the predetermined speed the sampling rate in relation to each other, the calculation and/or determination of the position sensor error may be facilitated since constant velocity may be assumed as reference.

According to some embodiments, the substrate pattern system may comprise a servo unit. The predetermined speed for moving the movable component may be kept above a lower limit speed, Vₘᵢₙ. The lower limit speed, Vₘᵢₙ, may be based on a servo bandwidth of the servo unit.

The servo unit may be configured to control the movement, the position and/or the displacement of one or more components of the substrate pattern system, such as the movable component. The servo unit may be connected to the at least one position sensor, directly and/or via a control unit. A control unit of the substrate pattern system may control the servo unit to move the movable component relative the base with a predetermined speed along the at least one axis of the at least one position sensor. The servo unit may comprise a motor and/or a feedback unit. For example, the servo unit may comprise an actuator. The servo unit may be configured to control or actuate the movement of the movable component. The servo unit may initiate and/or perform a movement of the movable component and move the movable component with the predetermined speed. The lower limit speed, Vₘᵢₙ, may be a minimum speed or a lower limit for the speed of the movable component, e.g. during the generation of position data in order to determine the position sensor error. The speed at which the movable component moves may preferably be maintained above the lower limit speed, Vₘᵢₙ. The predetermined speed may preferably be higher than the lower limit speed, Vₘᵢₙ. The servo bandwidth of the servo unit may relate to or indicate the response rate to changes in input of the servo unit, i.e., how quickly the servo unit responds to a change of input to the servo unit.

If the predetermined speed is below the lower limit speed, Vₘᵢₙ, the determination of the position sensor error may be less accurate/correct. The movement of the movable component may follow the position sensor error, more or less, e.g., if the predetermined speed is too low. This means that deviations, subtrends, or detrends (or frequencies thereof) included or indicated in the generated position data may fall within the servo bandwidth, which makes it difficult and/or close to impossible to detect or measure them in the position data. For example, as the deviations may fall within the servo bandwidth, the servo unit may have time to try to correct the deviations. By this, the movable component may move unevenly due to the impact of the position sensor error. This is because the at least one position sensor for which the position sensor error is being determined, is also the sensor used for generating position data and/or measuring the position of the movable component. That is, there are no other external references to rely on.

In another explanatory example, you can say that a servo, e.g. with a regulator, may compensate for servo errors up to a limit frequency. For higher frequencies, the response (e.g. an amplitude output to the motor, which may be expressed in decibel for example when quantifying gain/attenuation of signals within a system) drops by e.g. 40 dB per decade in frequency like a second-order filter. Hence, if the frequency of the error for a certain speed is e.g. >10x higher than the limit frequency, the servo's output signal will have decreased by 40dB. A higher speed may give a higher frequency on the error which in turn may give less influence of the servo on the speed caused by the error, wherein in this example the influence of the servo decreases by 40dB per decade in increased frequency of the error.

Therefore, to provide a clearer and more reliable measurement and/or determination of the position sensor error, the predetermined speed may beneficially be kept above a lower limit speed, Vₘᵢₙ. In that way, the deviations to be included or indicated in the generated position data may fall outside of the servo bandwidth and thereby be detected and determined in an efficient way.

According to some embodiments, the predetermined speed may be based on a property of the movable component

The movable component may vary in different substrate pattern systems and/or for different axes along which the position sensor error may be determined. In an example, the physical object that embodies the movable component along a first axis, A₁, may be different from the physical object that embodies the movable component along a first axis, A₂. Similarly, the physical object that embodies the movable component may differ between a first and a second substrate pattern system. The predetermined speed along the at least one axis may be selected or determined based on a property of the movable component. A property of the movable component that may need to be considered may be the size, the weight, the mass, the density, and/or the inertia. For example, the inertia of the movable component may determine the force required to change the speed or the velocity of the movable component. The predetermined speed may be based on one or more properties of the movable component. Hence, the predetermined speed may be selected/determined by/based on a property of one or more components in the substrate pattern system, such as the movable component. Furthermore, the predetermined speed may be based on a desired resolution/accuracy for the calculation of the position sensor error.

By adapting the predetermined speed depending on the properties of the movable component the method may provide a more accurate and facilitated determination of the position sensor error.

According to some embodiments, the predetermined speed may be based on at least one of the sampling rate and the fundamental period.

The predetermined speed, the sampling rate, and the fundamental period of the at least one position sensor may be interrelated. Since the fundamental period of the at least one position sensor in a specific set-up is fix, the predetermined speed and the sampling rate may be adapted/determined relative each other. The sampling rate may be based on a preferred number of samples per fundamental period. A higher number of samples per fundamental period provides improved sampled position data, e.g. in terms of accuracy and reliability. The sampling rate may further be based on the predetermined speed. A higher predetermined speed generally requires a higher sampling rate since the frequency of the position sensor error increases proportionally with the predetermined speed. It is to be understood that the selection of the predetermined speed and sampling rate may depend on the movable component, such as a property of the movable component. The predetermined speed may be selected/determined by/based on the number of samples needed for a measurement, e.g. the number of samples per fundamental period and/or a property of the movable component, such as the inertia of the movable component. The predetermined speed and the sampling rate may be selected or determined in relation to each other.

The relation between, and selection of, the predetermined speed and the sampling rate may facilitate and improve the determination of the position sensor error. For example, the predetermined speed may be sufficiently high to prevent the movement of the movable component from following the position sensor error, while still allowing for a sufficient number of samples per fundamental period (per period of the position sensor error).

According to some embodiments, the sampling rate for sampling the position data may be greater than or equal to a lower limit sampling rate, Sₘᵢₙ. The lower limit sampling rate, Sₘᵢₙ, may be based on a predetermined number of sampling points, SP, per fundamental period, FP, of the at least one position sensor. Preferably SP/FP may be greater than or equal to 10.

The lower limit sampling rate, Sₘᵢₙ, may be a minimum sampling rate or a lower limit for the sampling rate for sampling the position data in order to determine the position sensor error. The lower limit sampling rate, Sₘᵢₙ, may be based on a preferred predetermined number of sampling points, SP, per fundamental period, FP. The lower limit sampling rate, Sₘᵢₙ, may be based on the predetermined speed. The predetermined number of sampling points, SP, per fundamental period, FP, may at least be two. The position sensor error may comprise at least one overtone. An overtone is also known as a harmonic, and is a component frequency that is a multiple of the fundamental frequency of a periodic waveform. The lowest frequency wave in the waveform is generally called the fundamental frequency, while the higher frequency waves that are integer multiples of the fundamental frequency are called overtones or harmonics. The at least one overtone may have a period smaller than the period of the position sensor error. For example, the period of the at least one overtone may be defined as FP/n, wherein n is an integer, such as n=2,3,4, .... A first overtone may have the period FP/2 and a second overtone may have a period FP/3. The first overtone may have a frequency twice as large as the frequency of the position sensor error and the second overtone may have a frequency three times as large as the frequency of the position sensor error. Depending on how many overtones to capture in the sampled position data, and/or how accurate measurement of the position sensor error to obtain, the predetermined number of sampling points, SP, per fundamental period, FP, may vary. For example, the predetermined number of sampling points, SP, per period of the at least one overtone may be at least 10.

The lower limit sampling rate, Sₘᵢₙ, may ensure that a sufficient and/or preferred number of sampling points per fundamental period may be obtained. Thereby the position sensor error may be determined with improved accuracy and reliability.

According to some embodiments, moving the movable component may comprise moving the movable component a distance corresponding to at least the fundamental period of the at least one position sensor.

The method may comprise moving the movable component a distance and/or a length along the at least one axis corresponding to one or more fundamental periods of the at least one position sensor. The control unit may be configured to control the moving of the movable component a distance corresponding to at least the fundamental period of the at least one position sensor, e.g. together with the servo unit. By this present disclosure, at least one period of the position sensor error may be captured in the generated position data and/or sampled position data, if the period of the position error corresponds to the fundamental period of the at least one position sensor. Typically, the period of the position error is similar, and at least related, to the fundamental period of the position sensor. By moving the movable component a distance corresponding to at least the fundamental period the method may provide a more accurate and reliable determination of the position sensor error since at least one full period of the sensor error may be captured. Preferably, the movable component may be moved a distance corresponding to a plurality of fundamental periods of the at least one position sensor, for example two, three or four fundamental periods. By this, the sampled position data may capture a plurality of periods of the position sensor error, thereby facilitating detection of random errors, and thus, the determination of the position sensor error.

According to some embodiments, calculating the position sensor error may comprise at least one of filtering, interpolation and averaging.

The sampled position data may be processed in order to calculate or determine the position sensor error. The term "processed position data" used herein may refer to determined deviations or linear detrends of the sampled position data and/or the sampled position data, or its deviations, which has been processed in some way, e.g., by filtering, interpolation and/or averaging.

The sampled position data or the processed position data may be filtered. Based on the frequency of the position sensor error, which may depend on the fundamental period and the predetermined speed a filter suitable for the known frequency range of the position sensor error may be used. In an example, a high pass filter may be used for unwanted lower frequencies. In another example, a low pass filter may be used for electrical noise.

The sampled position data, or the processed position data, may be processed using interpolation. By using interpolation, the sampled position data, or the processed position data, may be resampled to align with a final resolution of the at least one position sensor. The final resolution of the at least one position sensor may be based on the fundamental period of the at least one position sensor. The final resolution of the at least one position sensor may be smaller, or shorter, than the fundamental period of the at least one position sensor. The relationship between the fundamental period and the final resolution of the at least one position sensor may be defined by or described by the power of two. For example, after interpolation, the processed position data may comprise a number of data points that corresponds to the final resolution of the at least one position sensor. In an example, a spline interpolation may be used, e.g., a cubic spline interpolation.

The sampled position data, or the processed position data, may be processed using averaging. In an example, the movable component may move a distance corresponding to a plurality of fundamental periods of the at least one position sensor. Thus, the sampled position data, or the processed position data may comprise data of a plurality of fundamental periods. The sampled position data, or the processed position data may be split into a plurality of segments of the fundamental period of the at least one position sensor. Thus, the length of a segment may correspond to, or be equal to, the fundamental period of the at least one position sensor. The plurality of segments may be averaged. This may provide one averaged fundamental period of the sampled position data or the processed data.

The periodic sensor error may be based on, calculated by or determined by the processed position data. The filtering, interpolation and/or averaging may be applied to the sampled position data or to data received by the combination of then sampled position data, the predetermined speed and/or the sampling rate.

By calculating the position sensor error using at least one of filtering, interpolation and averaging, the determination of the position sensor error may be improved in terms of accuracy and efficiency.

According to some embodiments, calculating the position sensor error may comprise at least one of:
- resampling the position data by performing spline interpolation of the sampled position data, and
- splitting the sampled position data and/or resampled position data into segments of the fundamental period of the at least one position sensor, and averaging the segments based on a property of the at least one position sensor.

Furthermore, performing the spline interpolation may be performed evenly and/or based on a final resolution of the sensor, wherein the final resolution may be the final resolution after all data processing/handling of the position data. The spline interpolation may advantageously be cubic spline interpolation. The property of the at least one position sensor may be the fundamental period, which would allow the segments to be averaged for at least one full period of the position sensor error. The combination of the resampling and the splitting is an even more beneficial alternative. The present embodiment is advantageous in that the position sensor error may be determined more accurately, and in a more efficient manner, allowing e.g. both a quicker and more precise determination of the position sensor error.

According to some embodiments, moving the movable component may comprise moving the movable component a distance corresponding to a plurality of the fundamental period of the at least one position sensor, and wherein generating position data may comprise generating position data related to the plurality of the fundamental period of the at least one position sensor. Calculating the position sensor error may comprise averaging of the sampled position data at least partially based on the fundamental period of the at least one position sensor.

The position data may comprise data for, or related to, a distance corresponding to the plurality of the fundamental periods of the at least one position sensor. By this, a plurality of periods of the position sensor error may be captured in the position data. In an example, the movable component may be moved a distance corresponding to e.g. 10 to 1000, such as 100, fundamental periods of the at least one position sensor.

According to some embodiments, the method may further comprise providing an air bearing between the movable component and the base.

The air bearing, or the air cushion, may be provided between the movable component and the base. The air bearing may be frictionless. In an example, the base may be a beam and the movable component may be a carriage movably arranged on the beam. The air bearing provided between the carriage and the beam may provide a frictionless movement of the carriage relative the beam. The air bearing may provide vibration isolation. By this, vibrations affecting the movable component and/or the base during movement of the movable component may be reduced. This, in turn, provides an improved smoothness as the movable component moves relative the base with a predetermined speed and thus improved accuracy of the generated position data. Furthermore, by providing an air bearing between the movable component and the base, and moving the movable component with a predetermined speed, a constant speed may be assumed as reference when determining/calculating the position sensor error.

According to some embodiments, the at least one axis may comprise a first axis and a second axis wherein the second axis is different from the first axis.

The first axis may be perpendicular to the second axis. The first axis and the second axis may span a plane. In an example, the first axis may be an X-axis and the second axis may be a Y-axis, which together span an XY-plane. The movable component, the base, and/or the at least one position sensor may be arranged or defined in the plane spanned by the first axis and the second axis. For example, the position sensor error for both the X-axis and the Y-axis of a position sensor, such as an interferometer, may be determined.

The present embodiment is advantageous in that the position sensor error may be determined for a plurality of axes, hence providing a multidimensional estimation of the position sensor error. This provides a method that allows for improved calibration of a substrate pattern system for a larger variety of situations/scenarios, to provide improved inspection/measurement/writing results and accuracy. Since the method provides calibration data for multiple dimensions for one or more position sensors.

According to a second aspect of the present disclosure, a method for compensating for a position sensor error in a substrate pattern system is provided. The substrate pattern system comprises a movable component, a base, and at least one position sensor. The at least one position sensor have a fundamental period and is configured to measure a position of the movable component along at least one axis. The method comprises determining a position sensor error along the at least one axis of the at least one position sensor according to an embodiment of the first aspect of the present disclosure. The method further comprises creating compensation data for the at least one axis of the at least one position sensor based on the determined position sensor error. Creating the compensation data comprises mapping the position data to the compensation data. The position data has a first resolution and the compensation data has a second resolution lower than or equal to the first resolution. The method further comprises compensating for the position sensor error by applying the compensation data to the position data.

The present disclosure, according to this second aspect, relates to an improved method for compensating for the position error by creating adapted compensation data, wherein the position data is mapped/linked/aligned to the compensation data. This allows a control unit of a substrate pattern system to more efficiently account for the position sensor error when inspecting/measuring/writing, essentially allowing for a faster and/or more efficient inspection/measurement/writing process. By aligning/mapping the position data having a first resolution to the compensation data having a second resolution, a control unit controlling the substrate pattern system may account for the position sensor error in a more timely and/or efficient manner. For example, the control unit may perform less processing in order to correct for the position error, resulting in faster and/or more efficient performance, which results in an improved result of an inspection/measurement/writing in the substrate pattern system. This is especially advantageous when the position data has a different resolution than the compensation data, i.e. when the first resolution is different from the second resolution. This embodiment may provide increased productivity for the substrate pattern system by allowing for more efficient data processing and controlling of the system. Hence, the present disclosure may reduce the demand on mechanical alignment for substrate pattern systems by determining a position sensor error and compensating for it.

The present disclosure according to the second aspect further relates to the idea of providing a method for compensating for a position sensor error in a substrate pattern system that may provide increased accuracy and quality within optical microlithography, and/or improve the positioning of a substrate that in some way is being processed in a substrate pattern system. The method for compensating for a position sensor error may be employed in systems where the optical microlithography is used or in systems that in some way examines, measures, or inspects a substrate that has been processed using optical microlithography.

It is to be understood that the method of the present disclosure may be performed by a control unit and/or any processing unit/processing circuitry. Hence, a control unit may be configured to create the compensation data. The method may be a computer implemented method, wherein each step may be performed by a control unit, such as a processing unit/computer. Hence, the step of creating the compensation data may be done/performed by a control unit. Furthermore, the step of compensating for the position sensor error may be done/performed by a control unit.

Creating compensation data for the at least one axis of the at least one position sensor may comprise compiling, assembling, and/or gathering compensation data for the at least one axis of the at least one position sensor. The compensation data is based on the determined position sensor error, meaning that the compensation data may be calculated, processed, or produced from the determined position sensor error. The compensation data may be structured in a suitable way to be applicable with the at least one position sensor, the positioning system and/or the substrate pattern system. In an example, the compensation data may be formed or structured in a table or a matrix. The compensation data may comprise, e.g., a set of compensation values for at least one axis of the at least one position sensor, and may be formed to fit any suitable mapping between the set of compensation values and the position data generated along the at least one axis by the at least one position sensor. The set of compensation values may be determined based on the determined position sensor error. For example, the set of compensation values may describe the compensation for each point (sampling point) in the sampled position data or the processed position data along a first axis of the at least one axis and for a first sensor of the at least one position sensor. The compensation data may be structured to map that set of compensation values to the position data along the first axis generated by the first sensor. The position sensor error may have a period equal to the fundamental period of the at least one position sensor. By this, the set of compensation values may describe the compensation for a full period, i.e., a full fundamental period, of the position sensor error. Since the position sensor error may repeat each period, the set of compensation values may be applied to the position data each fundamental period.

The position data generated by the at least one position sensor has a first resolution which may be related to or based on the fundamental period of that at least one position sensor. The first resolution of the position data may be based on a property of the at least position sensor generating the position data. The first resolution of the position data may correspond to and/or be equal to the final resolution of the at least one position sensor. The final resolution of the at least one position sensor may be based on the fundamental period of the at least one sensor and achieved using interpolation. In an example, the relationship between the fundamental period, FP, and the first resolution may be defined by or described by a power of two. For example, the first resolution may be expressed by FP/2", where n is an integer and 2ⁿ is the number of points in the position data per fundamental period, FP. The compensation data has a second resolution which may be expressed by FP/2^{m}, where m ≤ n, m is integer and 2^{m} is the number of points in the compensation data. In this case, if n=m, the first resolution is equal to the second resolution and a direct mapping between the compensation data and the position data may be possible. If m<n, the number of points in the compensation data is less than the number of points in the position data, that is, the second resolution is lower than the first resolution. Interpolation may be applied to the compensation data to achieve a second resolution that is equal to the first resolution. The number of points in the compensation data may be based on or correspond to the number of points in the sampled position data or the processed position data.

The compensation data may be aligned or synchronized with the position data generated by the at least one position sensor. The compensation data may be applied to the position data such that the position sensor error may be corrected in the position data. The compensation data may be stored or saved in a control unit or a computer-readable memory comprised in or connected to the substrate pattern system. The compensation data may be applied to the position data in real time during use of the substrate pattern system. By this, the accuracy of the at least one position sensor may be improved during use of the substrate pattern system, e.g., during a microlithographic process or an inspection of a substrate. This in turn provides improved accuracy and performance of the microlithographic process, the measurement or the inspection of a substrate in the substrate pattern system since the positioning via the at least one position sensor is more accurate.

It will be appreciated that any advantages or further explanations provided in more detail in relation to the method for determining a position sensor error according to the first aspect of the present disclosure may also apply mutatis mutandis to the method for compensating for a position sensor error according to this second aspect of the present disclosure.

The method according to the second aspect of the present disclosure allows for simultaneous compensation in different positions of a movable component relative a base, for different position sensors, and along different directions or axes. The method according to the second aspect of the present disclosure further allows for compensation for different substrate pattern systems. This allows a substrate pattern system to be calibrated with improved efficiency since the position sensor error related to the positioning system of the substrate pattern system may be compensated for with improved efficiency.

According to some embodiments, creating the compensation data may be based on an amplitude of the position sensor error along the at least one axis.

The present disclosure is advantageous in that the compensation data considers the amplitude of the position sensor error along the at least one axis when mapping the position data to the compensation data. This allows for even more accurate compensation for the position sensor error, why may in turn result in an improved result of the inspection/measuring/writing of the substrate pattern system.

According to a third aspect of the present disclosure, a substrate pattern system is provided. The substrate pattern system is configured to perform the method according to the first aspect of the present disclosure or the method according to the second aspect of the present disclosure. The substrate pattern system comprises a base and a moveable component. The substrate pattern system further comprises at least one position sensor having a fundamental period. The at least one position sensor is configured to measure a position of the movable component along at least one axis. The at least one position sensor is further configured to generate position data indicating a position of the movable component relative the base. The movable component is configured to move relative the base with a predetermined speed along the at least one axis. The substrate pattern system further comprises a control unit configured to sample the position data with a sampling rate to generate sampled position data. The control unit is further configured to calculate a position sensor error based on the sampled position data, the predetermined speed and the sampling rate.

The control unit may comprise the servo unit. The control unit and the servo unit may be separate units. The control unit and the servo unit may be connected to each other.

It will be appreciated that any features, advantages or further explanations provided in more detail in relation to the method for determining a position sensor error according to the first aspect of the present disclosure and/or the method for compensating for a position sensor error according to a second aspect of the present disclosure may also apply mutatis mutandis to the substrate pattern system according to the third aspect of the present disclosure.

According to some embodiments, the control unit may be configured to create compensation data for the at least one axis of the at least one position sensor based on the determined position sensor error for the at least one axis of the at least one position sensor. The control unit may further be configured to map the position data to the compensation data. The control unit may further be configured to compensate the substrate pattern system by applying the compensation data to the position data. The position data may have a first resolution and the compensation data may have a second resolution less than or equal to the first resolution.

It is to be understood that the creating the compensation data may include mapping the position data to the compensation data. Hence, the control unit may be configured to create compensation data for the at least one axis of the at least one position sensor based on the determined position sensor error for the at least one axis of the at least one position sensor by mapping the position data to the compensation data.

It is noted that other embodiments using all possible combinations of features recited in the above-described embodiments may be envisaged. Thus, the present disclosure also relates to all possible combinations of features mentioned herein.

### BRIEF DESCRIPTION OF THE DRAWINGS

Exemplifying embodiments will now be described in more detail, with reference to the following appended drawings:
Figs. 1A-1B schematically illustrate examples of a substrate pattern system in accordance with some embodiments of the present disclosure.
Fig. 2 schematically illustrates a top view of an example of a substrate pattern system in accordance with some embodiments of the present disclosure.
Fig. 3 schematically illustrates a flow diagram of a method for determining a position sensor error in a substrate pattern system in accordance with some embodiments of the first aspect of the present disclosure.
Fig. 4 schematically illustrates a flow diagram of a method for compensating for a position sensor error in a substrate pattern system in accordance with the second aspect of the present disclosure.
Fig. 5 schematically illustrates an example graph of a position sensor error of the at least one position sensor comprised in a substrate pattern system.

As illustrated in the figures, the sizes of the elements and regions may be exaggerated for illustrative purposes and, thus, are provided to illustrate the general structures of the embodiments. Like reference numerals refer to like elements throughout.

### DETAILED DESCRIPTION

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

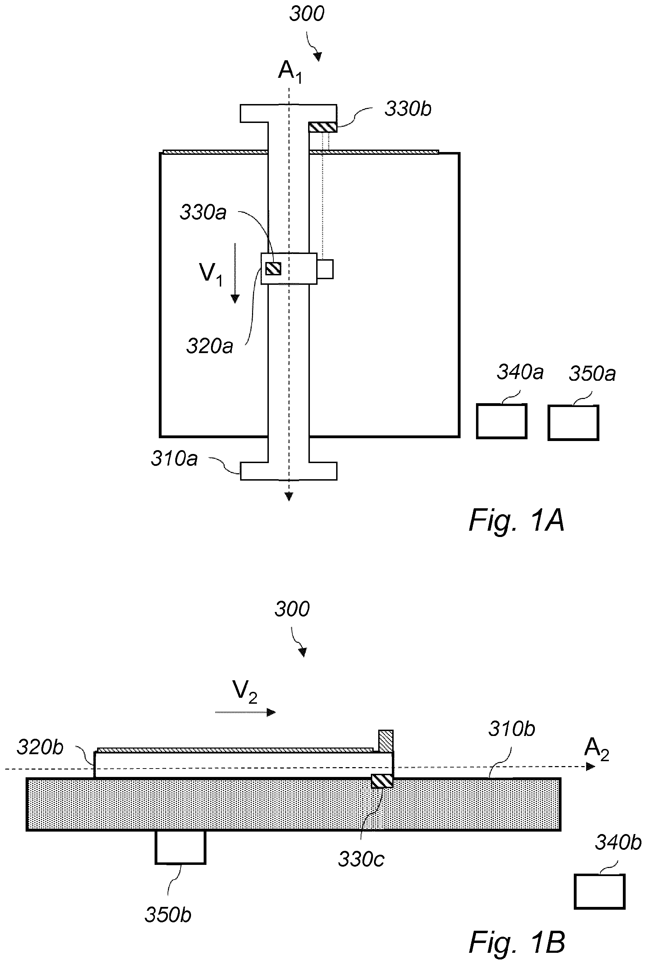

In Figs. 1A-1B, examples of a substrate pattern system 300 in accordance with the third aspect of the present disclosure are shown. Figs. 1A-1B illustrate different combinations/examples of a base 310, a movable component 320 and at least one position sensor 330 that may form a substrate pattern system 300 in which a position sensor error may be determined and/or compensated for.

In Fig. 1A, a substrate pattern system 300 is shown in a top view. The substrate pattern system 300 comprises a first base 310a and a first movable component 320a. As seen in Fig. 1A, the first movable component 320a may be movably arranged on/relative to the first base 310a, in a direction parallel to a first axis A₁. The first movable component 320a is configured to move with a speed V₁, relative the first base 310a, along the first axis A₁. In Fig. 1A, the first base 310a is a bridge or a beam, and the first movable component 320a may be a carriage or a tool head configured to move along the bridge/beam. The first movable component 320a, i.e., the carriage or the tool head in this example, may be configured to project or focus a light onto/from the substrate during, for example, a microlithography process, a pattern placement measurement or an inspection process.

The substrate pattern system 300 in Fig. 1A further comprises a first position sensor 330a and a second position sensor 330b. The first position sensor 330a is arranged/placed on/in/at the first movable component 320a. The first position sensor 330a may be an encoder. As illustrated in Fig. 1, the second position sensor 330b is arranged and/or placed on/in/at the first base 310a, however, it may be arranged at other locations in the substrate pattern system 300 and/or in other ways. The second position sensor 330b may be an interferometer. The first position sensor 330a and the second position sensor 330b may have a first fundamental period and a second fundamental period respectively. The first position sensor 330a is configured to measure a position of the first movable component 320a along the first axis A₁ and to generate position data based on the measured position. The position data generated by the first position sensor 330a indicates a position of the first movable component 320a relative the first base 310a. The second position sensor 330b is configured to measure a position of the first movable component 320a along the first axis A₁. The second position sensor 330b is configured to generate position data indicating a position of the first movable component 320a relative the first base 310a.

In Fig. 1A, the substrate pattern system further comprises a control unit 340a. The control unit 340a is connected to one or more of the other components of the substrate pattern system 300, such as the first position sensor 330a and/or second position sensor 330b. The control unit 340a may be configured to receive position data generated by the first position sensor 330a and/or the second position sensor 330b. The control unit 340a may be configured to sample the position data to generate sampled position data. The position data may be sampled with different sampling rates depending on the type of sensor, and its fundamental period, and the speed of the first movable component 320a during which the position data is generated. For example, the position data generated by the first position sensor 330a may be sampled with a first sampling rate, and the position data generated by the second position sensor 330b may be sampled with a second sampling rate, if the first movable component 320a moves with the speed V₁. The first sampling rate may be based on the first fundamental period, and the second sampling rate may be based on the second fundamental period.

The control unit 340a may be configured to calculate a position sensor error of the first position sensor 330a based on the sampled position data related to the first position sensor 330a, the speed V₁, and the first sampling rate. Similarly, the control unit 340a may be configured to calculate a position sensor error of the second position sensor 330b based on the sampled position data related to the second position sensor 330b, the speed V₁, and the second sampling rate. The control unit 340a may further be configured to create compensation data based on the calculated and/or determined position sensor error of the first position sensor 330a and second position sensor 330b respectively. The control unit 340a may map the compensation data of the first position sensor 330a to the position data of the first position sensor 330a. Similarly, the control unit 340a may map compensation data and position data of the second position sensor 330b. The control unit 340a may further compensate the substrate pattern system 300 by applying the compensation data to the position data generated by the first position sensor 330a and the second position sensor 330b respectively.

In Fig. 1A, the substrate pattern system 300 further comprises a servo unit 350a. The servo unit 350a may control the movement and/or the position of the first movable component 320a. The servo unit 350b may initiate a movement of the first movable component 320a such that the first movable component 320a moves with the speed V₁ along the first axis A₁ and/or relative the first base 310a. The servo unit 350a may be connected to the first movable component 320a, the first position sensor 330a, the second position sensor 330b and/or the control unit 340a in order to receive and/or send data, e.g. position data, and/or control signals, e.g. for moving the first movable component 320a. The substrate pattern system 300 may be configured to operate as a feedback-system. For example, the control unit 340a, the at least one position sensor 330 and the servo unit 350b may be connected and configured to communicate to create a feedback-system for controlling/improving the movement of the moveable component 320.

In Fig. 1B, a substrate pattern system 300 is shown in a side view. The substrate pattern system 300 comprises a second base 310b and a second movable component 320b. As seen in Fig. 1B, the second movable component 320b may is movably arranged on/relative to the second base 310b, along a second axis A₂. The second axis A₂ in Fig. 1B may be different from the first axis A₁ in Fig 1A, for example, the second axis A₂ may be orthogonal to the first axis A₁. The second movable component 320b is configured to move with a speed V₂, relative the second base 310b, along the second axis A₂. The second base 310b may be a base stone arranged to be static and the second movable component 320b may be a stage or a platform configured to move relative the base stone. In an example, the second movable component 320b, i.e., the stage/platform, may be configured to receive and/or hold a substrate. The substrate may be arranged and/or placed on the stage or the platform.

The substrate pattern system 300 in Fig. 1B further comprises a third position sensor 330c. The third position sensor 330c is arranged and/or placed at/on the second base 310b and/or the second movable component 320b. The third position sensor 330c may be arranged between and/or adjacent to the second base 310b and the second movable component 320b. However, the third position sensor 330c may be arranged at other locations in the substrate pattern system 300 and/or in other ways. The third position sensor 330c may be an encoder. The third position sensor 330c may have a third fundamental period. The third position sensor 330c is configured to measure a position of the second movable component 320b along the second axis A₂ and to generate position data based on the measured position. The position data generated by the third position sensor 330c indicates a position of the second movable component 320b relative the second base 310b.

In Fig. 1B, the substrate pattern system further comprises a control unit 340b. The control unit 340b may be connected to one or more of the other components of the substrate pattern system 300, such as the third position sensor 330c. The control unit 340b may be configured to receive position data generated by the third position sensor 330c. The control unit 340b may be configured to sample the position data to generate sampled position data. The position data may be sampled with different sampling rates depending on the type of position sensor, and its fundamental period, and the speed V₂ of the second movable component 320b during which the position data is generated. For example, the position data generated by the third position sensor 330c may be sampled with a third sampling rate, if the second movable component 320b moves with the speed V₂. The third sampling rate is based on the third fundamental period.

The control unit 340b may be configured to calculate a position sensor error of the third position sensor 330c based on the sampled position data related to the third position sensor 330c, the speed V₂, and the third sampling rate. The control unit 340b may further be configured to create compensation data based on the calculated and/or determined position sensor error of the third position sensor 330c. The control unit 340b may map the compensation data of the third position sensor 330c to the position data of the third position sensor 330c. The control unit 340b may further compensate the substrate pattern system 300 by applying the compensation data to the position data generated by the third position sensor 330c.

In Fig. 1B, the substrate pattern system further comprises a servo unit 350b. The servo unit 350b may control the movement and/or the position of the second movable component 320b. The servo unit 350b may initiate a movement of the second movable component 320b such that the second movable component 320b moves with the speed V₂ along the second axis A₂ and/or relative the second base 310b. The servo unit 350a may be connected to the second movable component 320a, the third position sensor 330a, and/or the control unit 340b in order to receive and/or send data, e.g. position data, and/or control signals, e.g. for moving the second movable component 320b.

The examples illustrated in Figs. 1A-1B illustrates substrate pattern systems with one or two position sensors, however, the number of position sensor may vary in different types of substrate pattern systems. It is understood that the arrangement or placement of the at least one position sensor may vary in different types of substrate pattern systems. Furthermore, it is to be understood that there are several different arrangements or set-ups of the base and the movable component, other than those shown in Figs. 1A-1B.

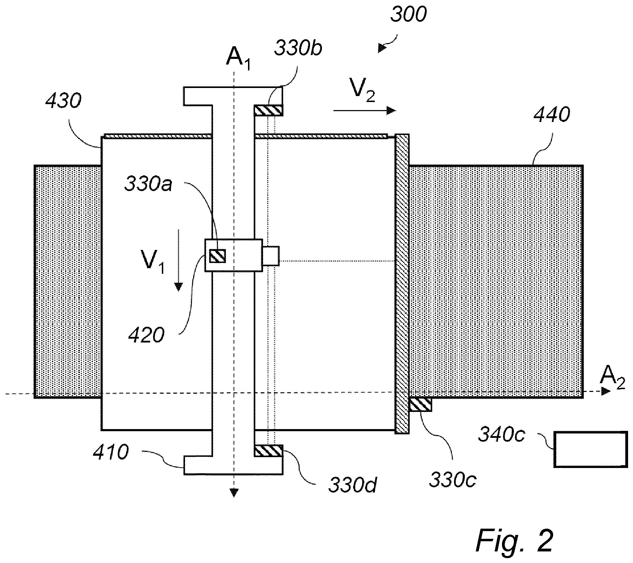

In Fig. 2, a substrate pattern system 300 in accordance with some embodiments of the present disclosure is shown in top view. The substrate pattern system 300 illustrated in Fig. 2 may comprise and/or combine one or more parts of the example substrate pattern systems in Figs. 1A-1B. Typically, a substrate pattern system 300 includes movement of components or parts in two or more directions, in order to cover the area of a substrate. In Fig. 2, the combination of components of the substrate pattern system 300 provides movement in a first direction parallel to the first axis A₁ and in a second direction parallel to the second axis A₂. The substrate pattern system 300 in Fig. 2 comprises a bridge 410, a tool head 420, a platform 430, and a base stone 440. The substrate pattern system 300 in Fig. 2 comprises several features in common with the substrate pattern system 300 in Figs. 1A-1B, such as a first position sensor 330a, a second position sensor 330b, and a third position sensor 330c as illustrated in Figs. 1A-1B. It is hereby referred to Figs. 1A-1B and the associated texts for an increased understanding of the features in Fig. 2.

In a first case, the tool head 420 is configured to move relative the bridge 410 along the first axis A₁. Therefore, along the first axis A₁, the tool head 420 is the movable component and the bridge 410 is the base. In the first case, the first position sensor 330a and the second position sensor 330b measure the position of the tool head 410, respectively, and generate position data, respectively. In a second case the platform 430 is configured to move relative the base stone 440 along the second axis A₂. Therefore, along the second axis A₂, the platform 430 is the movable component and the base stone 440 is the base. In the second case, the third position sensor 330c measures the position of the platform 430, and generates position data. The substrate pattern system in Fig. 2 further comprises a fourth position sensor 330d configured to measure the position of the tool head 420 relative the platform 430 along the second axis A₂. The fourth position sensor 330d may be used to measure the position of the platform 430.

In Fig. 2, the substrate pattern system 300 further comprises a control unit 340c. The control unit 340c may comprise a servo unit which may be configured to control/generate the movement and/or position of the tool head 420 and/or the platform 430. The control unit 340c receive position data from the first, second and/or third position sensors, 330a, 330b, 330c, and sample the respective position data with a respective sample rate. The respective sample rate may be based on the properties of the respective position sensor, such as its fundamental period, and/or the speed of the movable component for which the respective position data is generated.

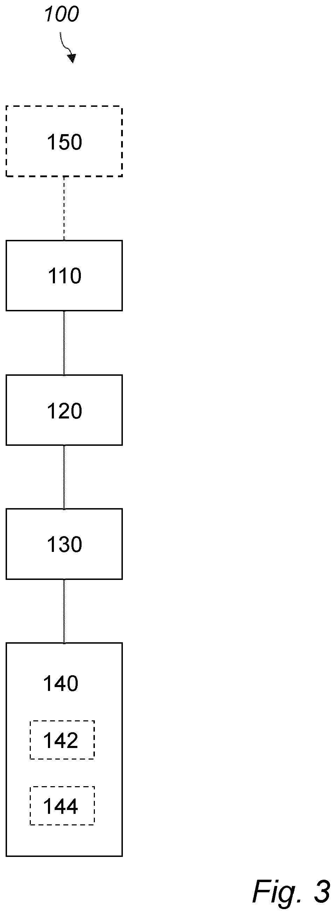

In Fig 3, a flow diagram of a method 100 for determining a position sensor error in a substrate pattern system in accordance with some embodiments of the present disclosure is illustrated. The method 100 may be performed in a substrate pattern system according to any embodiment of the third aspect of the present disclosure. The substrate pattern system may for example be one of the substrate pattern systems illustrated in Figs. 1A-1B and Fig. 2. As an example, the method 100 will hereafter be described with reference to the substrate pattern system in Fig. 1A. It is hereby referred to Figs. 1A-1B, Fig. 2 and the associated texts for an increased understanding of the features in the substrate pattern system.

The method 100 comprises moving 110 the movable component relative the base with a predetermined speed along the at least one axis. With reference to Fig. 1A, the first movable component 320a is moved with a predetermined speed V₁ along the first axis A₁ by the control unit 340a and/or the servo unit 350a. The predetermined speed V₁ may be calculated by the control unit 340a, pre-set and/or stored in the control unit 340a and/or the servo unit 350a. An operator of the substrate pattern system 300 may set the predetermined speed V₁. The predetermined speed V₁ may be kept above a lower limit speed, Vₘᵢₙ, that may be based on a servo bandwidth of the servo unit 350a. In general, for a system, such as a substrate pattern system 300 including at least one movable component 320, when improved accuracy is an objective, the predetermined speed V₁ may be kept above a speed limit in order to allow improved performance/accuracy, both for writing, inspection and measuring in substrate pattern systems. The predetermined speed V₁ may be based on a property of the first movable component 320a, such as the size, the weight or the inertia of the first movable component 320a. As shown in Fig. 1A, the first movable component 320a may be a tool head, which may be formed or designed in different ways depending on the application of the substrate pattern system 300. The predetermined speed V₁ may be based on the properties of, e.g., the tool head.

Moving 110 the movable component may comprise moving the movable component a distance corresponding to at least the fundamental period of the at least one position sensor which measures the position of the movable component. With reference to Fig. 1A, the first movable component 320a may be moved a distance corresponding to at least the first fundamental period of the first position sensor 330a, wherein the first position sensor 330a measures the position of the first movable component 320a. The first movable component 320a may be moved a distance corresponding to at least the second fundamental period of the second position sensor 330b, wherein the second position sensor 330b measures the position of the first movable component 320a. The control unit 340a and/or the servo unit 350a may control the distance that the first movable component 320a moves. The control unit 340a and the servo unit 350a may form a combined control/servo-unit.

In Fig. 3, the method further comprises generating 120 position data indicating a position of the movable component relative the base, by the at least one position sensor. With reference to Fig. 1A, the first position sensor 330a and/or the second position sensor 330b generate position data. During the generation of position data the speed of the first movable component 320a may be kept above the lower limit speed, Vₘᵢₙ, in order to determine the position sensor error.

As shown in Fig. 3, the method further comprises sampling 130 the position data with a sampling rate to generate sampled position data. The sampling rate is based on the fundamental period of the at least one position sensor. For example, the sampling rate may be greater than or equal to a lower limit sampling rate, Sₘᵢₙ, wherein Sₘᵢₙ may be based on a predetermined number of sampling points, SP, per fundamental period, FP. Preferably SP/FP may be greater than or equal to 10. The sampling rate may be greater than or equal to Sₘᵢₙ in order to determine the position sensor error. The predetermined speed may be based on the sampling rate and vice versa. For example, a predetermined number of sampling points per fundamental period and a predetermined speed of the movable component may result in a certain sampling rate. The sampling rate may determine a resolution of the sampled position data. Sampling 130 the position data may be performed together with or simultaneously as generating 120 position data. With reference to Fig. 1A, the control unit 340a may sample the position data received from the first position sensor 330a and/or the second position sensor 330b. The first position sensor 330a may sample the position data it generates if generating position data and sampling position data are performed at least partially simultaneously, and the same applies to the second position sensor 330b.

In Fig. 3, the method further comprises calculating 140 a position sensor error, by the control unit, the position sensor error along the at least one axis of the at least one position sensor based on the sampled position data, the predetermined speed and the sampling rate. Calculating 140 the position sensor error may comprise processing of the sampled position data. With reference to Fig. 1A, the control unit 340a calculates the position sensor error along the first axis A₁ of the first position sensor 330a and/or the second position sensor 330b. By moving the first movable component 320a relative the base 310a with a predetermined speed V₁ and sampling the position data with a sampling rate the position sensor error may be determined since a constant speed may be assumed as reference.

Calculating 140 the position sensor error may comprise at least one of filtering, interpolation and averaging. Calculating 140 the position sensor error may comprise filtering the sampled position data. The sampled position data may be filtered by using a filter suitable for the known frequency range of the position sensor error. In an example, a high pass filter may be used for unwanted lower frequencies. In another example, a low pass filter may be used for electrical noise. By filtering the sampled position data a cleaner signal or improved data of the position sensor error may be achieved. Calculating 140 the position sensor error may comprise interpolation of the sampled position data. The sampled position data may be interpolated such that the resolution of the sampled position data may align with the final resolution of the at least one position sensor (and/or the final resolution of the position data generated by the at least one position sensor). For example, a spline interpolation may be used, e.g., a cubic spline interpolation. Calculating 140 the position sensor error may comprise averaging of the sampled position data. In an example with reference to Fig. 1A, the first movable component 320a may move a distance corresponding to a plurality of first fundamental periods of the first position sensor 330a. Thus, the sampled position data, from the first position sensor 330a, may comprise data of a plurality of first fundamental periods. The sampled position data may be split into a plurality of segments of the first fundamental period. Thus, the length of a segment may correspond to, or be equal to, the first fundamental period. The plurality of segments may be averaged. Since the position sensor error of the first position sensor 330a may have a period corresponding to the first fundamental period, an averaged position sensor error of the first position sensor 330a may be obtained in this way, and this may in a similar way be applied to/described with the second position sensor 330b.

In an example, moving 110 the movable component may comprise moving the movable component a distance corresponding to at least a plurality of the fundamental period of the at least one position sensor. Generating 120 position data may comprise generating position data related to the plurality of the fundamental period of the at least one position sensor. Sampling 130 the position data may comprise sampling position data related to the plurality of the fundamental periods of the at least one position sensor. Calculating 140 the position sensor error may comprise averaging of the sampled position data at least partially based on the fundamental period of the at least one position sensor. Since the position sensor error of the at least one position sensor may have a period corresponding to the fundamental period, an averaged position sensor error of the at least one position sensor may be obtained in this way. This may provide an improved determination of the position sensor error in terms or reliability and accuracy.

Calculating the position sensor error may comprise resampling 142 the position data by performing cubic spline interpolation of sampled position data from one or more position sensors, preferably evenly sampled and aligned with the final resolution of the at least one position sensor. Furthermore, calculating the position sensor error may comprise splitting 144 the sampled position data and/or resampled position data into segments of the fundamental period of the at least one position sensor, and averaging the segments based on a property of the at least one position sensor, such that the segments are averaged to for one full period of the position sensor error.

As shown in Fig. 3, the method may further comprise providing 150 an air bearing between the movable component and the base. The air bearing may be provided by/in the substrate pattern system. For example, one or more outlets may be arranged on the base and/or the movable component such that air may flow through the outlets into a space between a surface of the movable component and a surface of the base. The flow of air may provide or create an air bearing such that a surface of the movable component and a surface of the base are separated. By providing 150 an air bearing between the movable component and the base, and moving 110 the movable component with a predetermined speed, a constant speed may be assumed as reference when determining/calculating the position sensor error. With reference to Fig. 1A, an air bearing or air cushion may be provided between the first movable component 320a and the second movable component 310a. The air bearing may provide a frictionless movement of the first movable component 320a relative the first base 310a.

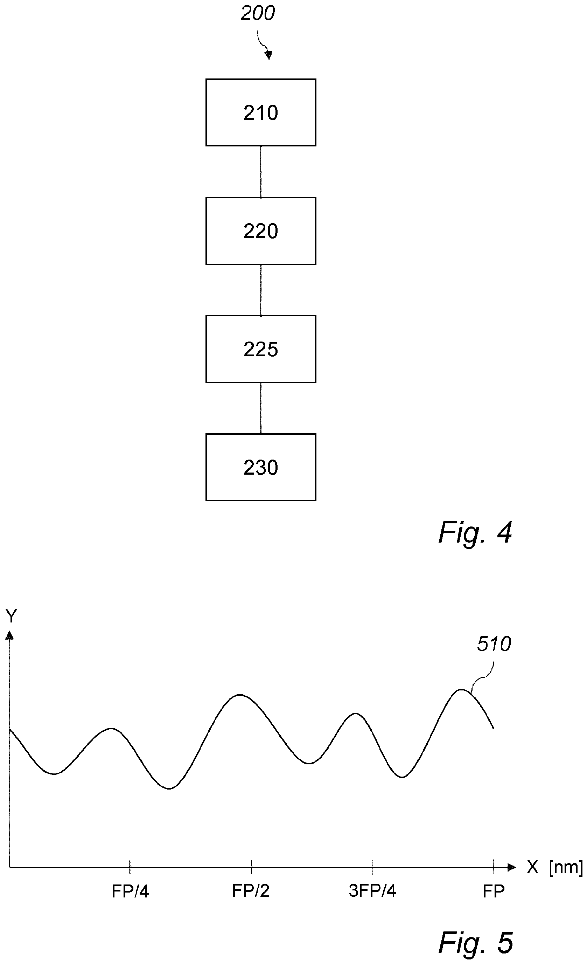

In Fig. 4, a flow diagram of a method 200 for compensating for a position sensor error in a substrate pattern system in accordance with the second aspect of the present disclosure is illustrated. The method 200 is performed in a substrate pattern system according to any embodiment of the third aspect of the present disclosure. The substrate pattern system may for example be one of the substrate pattern systems illustrated in Figs. 1A-1B and Fig. 2. It is hereby referred to Figs. 1A-1B, Fig. 2 and the associated texts for an increased understanding of the substrate pattern system. As an example, the method 200 will hereafter be described with reference to the substrate pattern system in Fig. 1A.

As seen in Fig. 4, the method 200 comprises determining 210 a position sensor error along the at least one axis of the at least one position sensor according to an embodiment of the first aspect of the present disclosure. With reference to Fig. 1A, a position sensor error may be determined along the first axis A₁ for the first position sensor 330a. In an example, the position sensor error may comprise a data signal and/or a set of data describing the position sensor error, e.g. in/for one full period of the position sensor error. For the first position sensor 330a in Fig 1A, the position sensor error may be described in/for one full first fundamental period of the first position sensor 330a. This may in a similar way be applied to/described with the second position sensor 330b.

In Fig. 4, the method 200 further comprises creating 220 compensation data for the at least one axis of the at least one position sensor based on the determined position sensor error. Creating 220 compensation data comprises mapping 225 the position data to the compensation data, i.e. the compensation data may be referred to as mapping/mapped compensation data. The position data has a first resolution and the compensation data has a second resolution lower than or equal to the first resolution. With reference to Fig. 1A, compensation data may be created by the control unit 340a. The compensation data for the first position sensor 330a along the first axis A₁ may be based on the determined position sensor error for the first position sensor 330a along the first axis A₁. The compensation data for the first position sensor 330a may comprise mapping to the position data generated along the first axis A₁ by the first position sensor 330a. For example, the mapped compensation data may be formed or structured in a table or a matrix in which a set of compensation values for the first axis A₁ of the first position sensor 330a may be mapped to the position data, which, for example, comprises a set of position data points/values. In an example, since the compensation data is based on the determined position sensor error, the compensation data may comprise a data signal and/or a set of data describing the compensation for the position sensor error in/for one full period of the position sensor error. For the first position sensor 330a in Fig 1A, the compensation data may be described in/for one full first fundamental period of the first position sensor 330a. The compensation data may then be applied to the position data for the first position sensor 330a repetitively for each first fundamental period. The position data generated by the first position sensor 330a may have a first resolution. The first resolution may correspond to the final resolution of the first position sensor 330a, which may be based on the first fundamental period and achieved using interpolation. The compensation data for the first position sensor 330a may have a second resolution being lower than or equal to the first resolution. Creating 220 compensation data may comprise performing interpolation of the compensation data such that the second resolution that is equal to the first resolution. The compensation data may be stored or saved in the control unit 340a or in a computer-readable memory comprised in or connected to the substrate pattern system 300. This may in a similar way be applied to the second position sensor 330b.

Creating 220 compensation data may be based on an amplitude of the position sensor error along the at least one axis. In an example, the characteristics of the position sensor error may change during the movement of the movable component. The position sensor error may, for example, be non-uniform and/or non-periodic as the movable component moves a distance corresponding to a plurality of fundamental periods of the at least one sensor. The compensation data may be adjusted and/or calculated based on the amplitude of the position sensor error for a respective fundamental period.

In Fig. 4, the method 200 further comprises compensating 230 for the position sensor error by applying the compensation data to the position data. With reference to Fig. 1A, the compensation data for the first position sensor 330a may be aligned or synchronized with the position data generated by the first position sensor 330a. The compensation data may be applied to the position data such that the position sensor error may be corrected in the position data. The compensation data may be applied to the position data in real time during use of the substrate pattern system 300. The compensation data stored in the control unit 340a may thus be applied to the position data generated by first position sensor 330a during use of the substrate pattern system 300, such as during a writing process, a pattern measurement and/or an inspection process. This may in a similar way be applied to the second position sensor 330b.

In Fig. 5 an example graph of a position sensor error 510, along at least one axis, of at least one position sensor comprised in a substrate pattern system is shown. In Fig 5, the position sensor error is illustrated as a graph 510. The position sensor error 510 has a period corresponding to the fundamental period, FP, of the at least one sensor. In Fig. 5, the horizontal axis, X, indicates a position in nanometer (nm), and the vertical axis, Y, may indicate, for example, a deviation in a unit of distance, e.g., nanometer (nm). One period (FP) of the position sensor error is shown in Fig. 5, and FP/4, FP/2, 3FP/4 and FP are indicated on the horizontal axis. In an example, the graph shown in Fig. 5 may illustrate a position sensor error 510 along a first axis (not shown) of a first position sensor (not shown), wherein the period of the position sensor error 510 corresponds to the fundamental period of that first position sensor.

Additionally, variations to the disclosed examples can be understood and effected by the skilled person in practicing the claimed invention, from a study of the drawings, the disclosure, and the appended claims. The mere fact that certain measures are recited in mutually different dependent claims does not indicate that a combination of these measures cannot be used to advantage. A feature described in relation to one aspect may also be incorporated in other aspects, and the advantage of the feature is applicable to all aspects in which it is incorporated. Other objectives, features, and advantages of the present inventive concept will appear from the detailed disclosure, from the attached claims as well as from the drawings.

Generally, all terms used in the claims are to be interpreted according to their ordinary meaning in the technical field, unless explicitly defined otherwise herein. In the claims, the word "comprising" does not exclude other elements. Further, the use of terms "first", "second", and "third", and the like, herein do not denote any order, quantity, or importance, but rather are used to distinguish one element from another. All references to "a/an/the [element, device, component, means, step, etc.]" are to be interpreted openly as referring to at least one instance of said element, device, component, means, step, etc., unless explicitly stated otherwise. The steps of any method disclosed herein do not have to be performed in the exact order disclosed, unless explicitly stated.

## Claims

1. A method (100) for determining a position sensor error in a substrate pattern system, wherein the substrate pattern system comprises a control unit, a movable component, a base, and at least one position sensor having a fundamental period and configured to measure a position of the movable component along at least one axis the method comprising:
moving (110) the movable component relative the base with a predetermined speed along the at least one axis,
generating (120) position data indicating a position of the movable component relative the base, by the at least one position sensor,
sampling (130) the position data with a sampling rate to generate sampled position data, wherein the sampling rate is based on the fundamental period of the at least one position sensor,
calculating (140), by the control unit, the position sensor error along the at least one axis of the at least one position sensor based on the sampled position data, the predetermined speed and the sampling rate.

2. The method according to claim 1, wherein the substrate pattern system comprises a servo unit, and wherein the predetermined speed for moving the movable component is kept above a lower limit speed, Vₘᵢₙ, based on a servo bandwidth of the servo unit.

3. The method according to any one of the preceding claims,
wherein the predetermined speed is based on a property of the movable component.

4. The method according to any one of the preceding claims,
wherein the predetermined speed is based on at least one of the sampling rate and the fundamental period.

5. The method according to any one of the preceding claims,
wherein the sampling rate for sampling the position data is greater than or equal to a lower limit sampling rate, Sₘᵢₙ, based on a predetermined number of sampling points, SP, per fundamental period, FP, of the at least one position sensor, wherein preferably SP/FP is greater than or equal to 10.

6. The method according to any one of the preceding claims,
wherein moving the movable component comprises moving the movable component a distance corresponding to at least the fundamental period of the at least one position sensor.

7. The method according to any one of the preceding claims,
wherein calculating the position sensor error comprises at least one of filtering, interpolation and averaging.

8. The method according to claim 7, wherein calculating the position sensor error comprises at least one of:
resampling (142) the position data by performing spline interpolation of the sampled position data, and
splitting (144) the sampled position data and/or resampled position data into segments of the fundamental period of the at least one position sensor, and averaging the segments based on a property of the at least one position sensor.

9. The method according to any one of the preceding claims,
wherein moving the movable component comprises moving the movable component a distance corresponding to a plurality of the fundamental period of the at least one position sensor, and wherein generating position data comprises generating position data related to the plurality of the fundamental period of the at least one position sensor, and wherein calculating the position sensor error comprises averaging of the sampled position data at least partially based on the fundamental period of the at least one position sensor.

10. The method according to any one of the preceding claims,
wherein the method further comprises providing (150) an air bearing between the movable component and the base.

11. The method according to any one of the preceding claims,
wherein the at least one axis comprises a first axis and a second axis wherein the second axis is different from the first axis.

12. A method (200) for compensating for a position sensor error in a substrate pattern system, wherein the substrate pattern system comprises a movable component, a base, and at least one position sensor having a fundamental period and configured to measure a position of the movable component along at least one axis the method comprising:
determining (210) a position sensor error along the at least one axis of the at least one position sensor according to any one of claims 1-11;
creating (220) compensation data for the at least one axis of the at least one position sensor based on the determined position sensor error, comprising mapping (225) the position data to the compensation data, wherein the position data has a first resolution and the compensation data has a second resolution lower than or equal to the first resolution,
compensating (230) for the position sensor error by applying the compensation data to the position data.

13. The method according to claim 12, wherein creating the compensation data is based on an amplitude of the position sensor error along the at least one axis.

14. A substrate pattern system (300) configured to perform the method according to any one of claims 1-11 or the method according to any one of claims 12-13, wherein the substrate pattern system comprises:
a base (310) and a moveable component (320),
at least one position sensor (330) having a fundamental period, FP, and configured to measure a position of the movable component along at least one axis and generate position data indicating a position of the movable component relative the base,
wherein the movable component is configured to move relative the base with a predetermined speed along the at least one axis,
a control unit (340) configured to sample the position data with a sampling rate to generate sampled position data, and configured to calculate a position sensor error based on the sampled position data, the predetermined speed and the sampling rate.

15. The substrate pattern system according to claim 14, wherein the control unit is configured to create compensation data for the at least one axis of the at least one position sensor based on the determined position sensor error for the at least one axis of the at least one position sensor and map the position data to the compensation data, and compensate the substrate pattern system by applying the compensation data to the position data, wherein the position data has a first resolution and the compensation data has a second resolution less than or equal to the first resolution.
